# EUROPÄISCHE PATENTSCHRIFT

(11) **EP 2 989 052 B1**
(45) Veröffentlichungstag und Bekanntmachung des Hinweises auf die Patenterteilung: **30.05.2018**
(21) Anmeldenummer: 14714215.2
(22) Anmeldetag: 24.03.2014
(51) Int. Cl.: C01B 33/035, G01N 29/00, G01N 21/00, B02C 23/08, C23C 16/01, C23C 16/24, C23C 16/56, G01N 29/09, H01L 31/028, H01L 31/0368

(54) **VERFAHREN ZUR HERSTELLUNG VON POLYKRISTALLINEM SILICIUM**
PROCESS FOR THE PREPARATION OF POLYCRYSTALLINE SILICON
PROCÉDÉ DE PRODUCTION DE SILICIUM POLYCRISTALLIN

(30) Priorität: 22.04.2013 DE 102013207251
(43) Veröffentlichungstag der Anmeldung: 02.03.2016
(73) Patentinhaber: Wacker Chemie AG, 81737 München (DE)
(72) Erfinder: KERSCHER, Michael, 84508 Burgkirchen (DE); PECH, Reiner, 84524 Neuötting (DE); SANDNER, Armin, 84561 Mehring (DE)
(74) Vertreter: Potten, Holger
(86) Internationale Anmeldenummer: PCT/EP2014/055837
(87) Internationale Veröffentlichungsnummer: WO 2014/173596

(56) Entgegenhaltungen:
- EP-A1- 1 895 297
- EP-A1- 2 453 042
- EP-A1- 2 620 412
- EP-A2- 2 036 856

## Beschreibung

Die Erfindung bezieht sich auf ein Verfahren zur Herstellung von polykristallinem Silicium.

Polykristallines Silicium (kurz: Polysilicium) dient als Ausgangsmaterial zur Herstellung von einkristallinem Silicium für Halbleiter nach dem Czochralski(CZ)- oder Zonenschmelz(FZ)-Verfahren, sowie zur Herstellung von ein- oder multikristallinem Silicium nach verschiedenen Zieh- und GießVerfahren zur Produktion von Solarzellen für die Photovoltaik.

Polykristallines Silicium wird in der Regel mittels des Siemens-Verfahrens hergestellt. Bei diesem Verfahren werden in einem glockenförmigem Reaktor ("Siemens-Reaktor") Trägerkörper, üblicherweise dünne Filamentstäbe aus Silicium, durch direkten Stromdurchgang erhitzt und ein Reaktionsgas enthaltend Wasserstoff und eine oder mehrere siliciumhaltige Komponenten eingeleitet.

Üblicherweise wird als siliciumhaltige Komponente Trichlorsilan (SiHCl₃, TCS) oder eine Mischung von Trichlorsilan mit Dichlorsilan (SiH₂Cl₂, DCS) und/oder mit Tetrachlorsilan (SiCl₄, STC) eingesetzt. Seltener, aber auch im industriellen Maßstab wird Silan (SiH₄) verwendet.

Die Filamentstäbe stecken senkrecht in am Reaktorboden befindlichen Elektroden, über die der Anschluss an die Stromversorgung erfolgt.

An den erhitzten Filamentstäben und der waagrechten Brücke scheidet sich hochreines Polysilicium ab, wodurch deren Durchmesser mit der Zeit anwächst.

Nach Abkühlung der Stäbe wird die Reaktorglocke geöffnet und die Stäbe werden per Hand oder mit Hilfe von speziellen Vorrichtungen, sogenannten Ausbauhilfen zur Weiterverarbeitung bzw. zur zwischenzeitlichen Lagerung entnommen.

Sowohl die Lagerung als auch die Weiterverarbeitung, vor allem ein Zerkleinern der Stäbe, ein Klassieren und eine Verpackung gebrochener Stücke, erfolgen in der Regel unter besonderen Umgebungsbedingungen in klimatisierten Räumen, was eine Verunreinigung des Produktes verhindert.

Zwischen dem Zeitpunkt des Öffnens des Reaktors und bis zur Einlagerung bzw. Weiterverarbeitung ist das abgeschiedene Material allerdings umgebungsbedingten Einflüssen, insbesondere Staubpartikelchen, ausgesetzt.

Morphologie und Mikrostruktur des wachsenden Stabes werden von den Parametern des Abscheideprozesses bestimmt.

Die Morphologie der abgeschiedenen Stäbe kann von kompaktem und glattem (wie z.B. in US 6,350,313 B2 beschrieben) bis zu sehr porösem und zerklüftetem Material (wie beispielweise in US2010/219380 A1 beschrieben) variieren.

Bei der Herstellung dicker polykristalliner Siliciumstäbe (mit Durchmesser >100 mm) in den Siemens-Reaktoren nach dem Stand der Technik ist relativ häufig zu beobachten, dass die Stäbe Bereiche mit sehr rauer Oberfläche ("Popcorn") aufweisen. Diese rauen Bereiche müssen von dem restlichen Material, üblicherweise durch visuelle Kontrolle nach dem Brechen, abgetrennt und zu wesentlich niedrigeren Preisen als der restliche Siliciumstab verkauft werden.

Die Steigerung der Grundparameter bei der Abscheidung (Temperatur der Stäbe, spezifischer Durchfluss, Konzentration) führt im Allgemeinen zur Erhöhung der Abscheidegeschwindigkeit und damit zur Verbesserung der Wirtschaftlichkeit des Abscheideprozesses.

Jedem dieser Parameter sind allerdings natürliche Grenzen gesetzt, bei deren Überschreitung der Herstellprozess gestört wird (je nach Konfiguration des eingesetzten Reaktors liegen die Grenzen etwas unterschiedlich).

Wird z.B. die Konzentration der siliciumhaltigen Komponente zu hoch gewählt, kommt es gegebenenfalls zu homogener Gasphasenabscheidung.

Eine zu hohe Stab-Temperatur kann dazu führen, dass die Morphologie der abzuscheidenden Siliciumstäbe nicht kompakt genug wird, um dem mit dem wachsenden Stabdurchmesser steigenden Stromdurchfluss eine ausreichende Querschnittfläche zur Verfügung zu stellen.

Zu hoch werdende Stromdichte kann dabei das Schmelzen von Silicium verursachen.

Bei Stäben mit großem Durchmesser (ab 120 mm) ist die Temperaturwahl noch kritischer, da selbst bei kompakter Morphologie Silicium im Stabinneren (aufgrund der hohen Temperaturdifferenzen zwischen der Oberfläche und dem Stabzentrum) flüssig werden kann.

Auch Anforderungen an das Produkt von Kunden aus Halbleiter- und Solar-Industrie schränken die Bereiche der Prozessparameter deutlich ein.

So werden zum Beispiel für FZ-Anwendungen Siliciumstäbe benötigt, die von Rissen, Poren, Fugen, Klüften, usw. weitestgehend frei und damit homogen, dicht und fest sind. Außerdem sollten sie für eine bessere Ausbeute beim FZ-Ziehen bevorzugt eine besondere Mikrostruktur ausweisen. Ein derartiges Material und das Verfahren zu seiner Herstellung werden beispielsweise in US2008/286550 A1 beschrieben.

Für die Herstellung von Nachchargierstäben und sogenannten Cutrods, die hauptsächlich beim CZ-Verfahren zur Steigerung des Tiegelfüllgrades eingesetzt werden, werden ebenfalls rissfreie und spannungsarme polykristalline Silicium-Rohstäbe benötigt.

Für die meisten Anwendungen werden polykristalline Siliciumstäbe allerdings auf kleine Stücke gebrochen, welche üblicherweise anschließend nach Größen klassiert werden.

Eine Verfahren und eine Vorrichtung zum Zerkleinern und Sortieren von Polysilicium ist beispielweise in US 2007/235574 A1 beschrieben.

EP 1895297 A1 offenbart eine Ultraschallprüfung an Polysiliciumformkörpern, mit der Defekte im Volumen des Formkörpers detektiert werden können. Bei den Formkörpern handelt es sich um Stäbe oder Stabstücke. Durch das Verfahren können zylindrische und konische Formkörper für einen FZ-Umschmelzprozess auf Materialfehlstellen hin untersucht werden.

US 2009081108 A1 offenbart eine Werkbank zum manuellen Sortieren von polykristallinem Silicium nach Größe und Qualität. Dabei ist Ionisationssystem implementiert, um durch aktive Luftionisation elektrostatische Ladungen zu neutralisieren. Ionisatoren durchsetzen die Reinraumluft derart mit Ionen, dass statische Ladungen an Isolatoren und ungeerdeten Leitern abgebaut werden.

US 2007235574 A1 offenbart eine Vorrichtung zum Zerkleinern und Sortieren von polykristallinem Silicium, umfassend eine Aufgabeeinrichtung für einen Polysilicium-Grobbruch in eine Brecheranlage, die Brecheranlage, und eine Sortieranlage zum Klassieren des Polysilicium-Bruchs, dadurch gekennzeichnet, dass die Vorrichtung mit einer Steuerung versehen ist, die eine variable Einstellung mindestens eines Brechparameters in der Brecheranlage und/oder mindestens eines Sortierparameters in der Sortieranlage ermöglicht. Ein Polysiliciumstab wird auf den Bruchtisch des Vorzerkleinerers gelegt. Auf dem Bruchtisch erfolgt eine visuelle Qualitätskontrolle des Stabes auf Fremdkörper, Beläge und Morphologie der Oberfläche. Der Stab wird auf einen Brechschlitten gelegt, der den Stab automatisch in die Brechkammer fördert.

Bei der Verarbeitung auf Bruchstücke werden als Ausgangsmaterial Stäbe mit Rissen und weiteren Materialfehlern akzeptiert.

Die Morphologie polykristalliner Stäbe sowie daraus entstandener Bruchstücke hat jedoch einen starken Einfluss auf die Performance des Produkts. Üblicherweise hat eine poröse und zerklüftete Morphologie eine negative Auswirkung auf das Kristallisationsverhalten.

Besonders stark betroffen ist das anspruchsvolle CZ-Verfahren, bei welchem wegen der wirtschaftlich nicht akzeptablen Ausbeuten poröse und zerklüftete Bruchstücke nicht eingesetzt werden konnten.

Andere Kristallisationsverfahren (z.B. das zur Herstellung von Solarzellen am häufigsten eingesetzte Blockgießen) sind weniger Morphologieempfindlich. Hier kann der negative Einfluss des porösen und zerklüfteten Materials durch seine geringeren Herstellkosten wirtschaftlich kompensiert werden.

Problematisch ist, dass bei der Herstellung kompakten Materials im Bereich der Staboberseiten manchmal auch poröse Anteile entstehen. Bei anspruchsvollen Kundenanwendungen sind poröse Stabanteile jedoch nicht erwünscht, so dass die Reaktorfahrkurven "konservativer" geplant werden müssen als eigentlich nötig, um auch die letzten porösen Anteile zu vermeiden.

Andererseits entstehen bei der Herstellung von porösem Silicium auch kompakte Anteile an den Stabunterteilen sowie an den der Reaktorwand zugewandten Stabseiten.

Teilweise sind bestimmte Stabteile stärker mit Verunreinigungen kontaminiert als andere. EP 2479142 A1 offenbart ein Verfahren zur Herstellung eines polykristallinen Siliciumstücks, umfassend Abscheidung von polykristallinem Silicium auf einem Trägerkörper in einem Reaktor, Entnahme des polykristallinen Siliciumstabs aus dem Reaktor sowie Zerkleinerung des Siliciumstabs in Siliciumstücke, wobei vor dem Zerkleinern mindestens 70 mm ab dem Elektrodenende vom polykristallinen Siliciumstab entfernt werden. Hier wird also vor der Zerkleinerung des Stabs in Bruchstücke ein Stabteil abgetrennt. Die durch Zerkleinerung des Reststabs erhaltenen Bruchstücke weisen einen niedrigen Gehalt an Chrom, Eisen, Nickel, Kupfer und Kobalt auf.

Aus dieser Problematik ergab sich die Aufgabenstellung der Erfindung.

Die Aufgabe wird gelöst durch ein Verfahren zur Herstellung von polykristallinem Silicium, umfassend Abscheiden von polykristallinem Silicium auf in wenigstens einem Reaktor befindlichen Trägerkörpern, wodurch polykristalline Siliciumstäbe erhalten werden, Ausbau der polykristallinen Siliciumstäbe aus dem wenigstens einen Reaktor, Zerkleinern der ausgebauten polykristallinen Siliciumstäbe in Bruchstücke, dadurch gekennzeichnet, dass nach dem Ausbau der polykristallinen Siliciumstäbe aus dem wenigstens einen Reaktor und vor dem Zerkleinern der ausgebauten polykristallinen Siliciumstäbe in Bruchstücke das in Stabform vorliegende polykristalline Silicium anhand wenigstens eines Merkmals in wenigstens zwei Qualitätsklassen klassifiziert wird, wobei jene wenigstens zwei Qualitätsklassen separaten Zerkleinerungsschritten zugeführt werden.

Die Erfindung sieht also vor, an den ausgebauten Siliciumstäben eine Klassifizierung in wenigstens zwei Qualitätsklassen vorzunehmen. Diese Klassifizierung erfolgt vor der Zerkleinerung der Stäbe in Bruchstücke.

Im Rahmen der Erfindung ist unter Zerkleinerung in Bruchstücke der Zerkleinerungsschritt unmittelbar vor dem Verpacken des polykristallinen Siliciums oder einem dem Verpacken vorgelagerten Reinigungsschritt zu verstehen.

Beim Zerkleinern in Bruchstücke ergeben sich Bruchgrößen, die folgenden Größenklassen zugeordnet werden können, die jeweils als längste Entfernung zweier Punkte auf der Oberfläche eines Siliciumbruchstücks (=max. Länge) definiert sind:
Bruchgröße 0 [mm] 1 bis 5;
Bruchgröße 1 [mm] 4 bis 15;
Bruchgröße 2 [mm] 10 bis 40;
Bruchgröße 3 [mm] 20 bis 60;
Bruchgröße 4 [mm] 45 bis 120;
Bruchgröße 5 [mm] 90 bis 200
Bruchgröße 6 [mm] 130 bis 400

Ein Brechen der polykristallinen Siliciumstäbe in Stabteile oder ein Entfernen einer Oberfläche eines polykristallinen Siliciumstabs oder die Entnahme einer Probe aus dem Siliciumstab zu Analysezwecken, insbesondere zur Untersuchung hinsichtlich eines Klassifikationsmerkmals, soll im Rahmen der Erfindung nicht als Zerkleinern des polykristallinen Siliciumstabs verstanden werden.

Die Klassifizierung in wenigstens zwei Qualitätsklassen kann bezüglich der aus nur einem Reaktor entnommenen polykristallinen Siliciumstäbe erfolgen. Es ist aber auch bevorzugt, mehrere Reaktoren zu betrachten und die polykristallinen Siliciumstäbe aus diesen Reaktoren zu klassifizieren.

Als unterschiedliche Produktklassen können auch unterschiedliche Bruchgrößen aufgefasst werden, so kann z.B. ein Zerkleinerungsschritt "Zerkleinern zu Bruchgröße 5", ein anderer, unterschiedlicher Zerkleinerungsschritt "Zerkleinern zu Bruchgröße 3" lauten.

Die Klassifikation kann vorsehen, dass ganze Stäbe bestimmten Qualitätsklassen zugeordnet werden.

Es kann auch vorgesehen sein, abgetrennte Teile von Stäben bestimmten Qualitätsklassen zuzuordnen.

Ebenso kann ein mit Silicium gefülltes Transportmittel anhand einer dem Transportmittel entnommenen Stichprobe einer bestimmten Qualitätsklasse zugeordnet werden.

Die nachfolgend angeführten Klassifikationsmerkmale werden vorzugsweis einzeln oder in allen möglichen Kombinationen angewendet.

Beim Klassifikationsmerkmal kann es sich um das Merkmal "Position des Siliciums im Stab" handeln.

Beim Klassifikationsmerkmal kann es sich um das Merkmal "Position des Stabes im Reaktor" handelt.

Beim Klassifikationsmerkmal kann es sich um ein optisch erkennbares Merkmal handeln.

Beim Klassifikationsmerkmal kann es sich um ein messbares Merkmal handeln.

Dabei kann es sich um ein mechanisch messbares Merkmal handeln, ausgewählt aus der Gruppe bestehend aus Härte der Stäbe bzw. Stabteile, Biegefestigkeit der Stäbe bzw. Stabteile, Zugfestigkeit der Stäbe bzw. Stabteile, Druckbeständigkeit der Stäbe bzw. Stabteile, Scherbeständigkeit der Stäbe bzw. Stabteile, Klang der Stäbe bzw. Stabteile nach mechanischer Anregung, Eigenschwingungsfrequenz der Stäbe bzw. Stabteile, Bruchverhalten der Stäbe bzw. Stabteile spontan oder beim Brechen mit verschiedenen Methoden (mechanisch, thermisch, elektrisch), Spannungen innerhalb der Stäbe bzw. Stabteile und Trägheitsmoment der Stäbe bzw. Stabteile und Kombinationen der genannten Merkmale.

Ebenso kann es sich um ein elektromagnetisch / nuklear messbares Merkmal handeln, ausgewählt aus der Gruppe bestehend aus Wärmeleitfähigkeit der Stäbe bzw. Stabteile, elektr. Widerstand der Stäbe bzw. Stabteile, elektromagnetische Permeabilität der Stäbe bzw. Stabteile, Brechungsindizes der Stäbe bzw. Stabteile für elektromagnetische Wellen, Brechungsindizes der Stäbe bzw. Stabteile für Schall-, Infraschall- und Ultraschallwellen, Farbe der Stäbe bzw. Stabteile, Absorptionsspektrum der Stäbe bzw. Stabteile, Emissionsspektrum der Stäbe bzw. Stabteile nach Anregung (z.B. thermisch, elektrisch, optisch) oder im "Ist-Zustand", Röntgenbeugungsverhalten der Stäbe bzw. Stabteile, Röntgenabsorptionsverhalten der Stäbe bzw. Stabteile, Neutronenbeugungsverhalten der Stäbe bzw. Stabteile, Neutronenabsorptionsverhalten der Stäbe bzw. Stabteile, Kernspinresonanzverhalten der Stäbe bzw. Stabteile, elektrische Kapazität der Stäbe bzw. Stabteile, elektromagnetische Induktivität der Stäbe bzw. Stabteile, Magnetisierung der Stäbe bzw. Stabteile, magnetisches Moment der Stäbe bzw. Stabteile, magnetische Suszeptibilität der Stäbe bzw. Stabteile, Radioaktivität der Stäbe bzw. Stabteile, Isotopenzusammensetzung der Stäbe bzw. Stabteile, Neutronenaktivierbarkeit der Stäbe bzw. Stabteile, Glanz der Stäbe bzw. Stabteile, Reflektivität der Oberfläche der Stäbe bzw. Stabteile für verschiedene Wellenlängen elektromagnetischer Strahlung, Reflektivität von Bruchflächen der Stäbe bzw. Stabteile für verschiedene Wellenlängen elektromagnetischer Strahlung, Wärmeübergangskoeffizient der Oberfläche bzw. Bruchfläche von der Stäbe bzw. Stabteile, Impedanz der Stäbe bzw. Stabteile für elektromagnetische oder Schallwellen unterschiedlicher Frequenzen und elektrische Polarisierbarkeit der Stäbe bzw. Stabteile und elektrische Permittivität der Stäbe bzw. Stabteile und Kombinationen der genannten Merkmale.

Das messbare Merkmal kann weiterhin ausgewählt sein aus der Gruppe bestehend aus Flecken auf der Oberfläche der Stäbe bzw. Stabteile, Oberflächenverformungen der Stäbe bzw. Stabteile, Oberflächenstruktur der Stäbe bzw. Stabteile, Dicke der Stäbe bzw. Stabteile, Form der Stäbe bzw. Stabteile, Länge der Stäbe, Gewicht der Stäbe bzw. Stabteile, Porosität der Stäbe bzw. Stabteile, Dichte der Stäbe bzw. Stabteile und Aussehen der Stäbe bzw. Stabteile (optischer persönlicher Qualitätseindruck) und Kombinationen der genannten Merkmale.

Beim Klassifikationsmerkmal kann es sich beispielsweise um den Stabdurchmesser handeln.

Beim Klassifikationsmerkmal kann es sich um das Merkmal "Kontamination der Oberfläche oder des Volumens" handeln.

Dabei kann nach oberflächlicher Kontamination der Stäbe bzw. Stabteile mit Metallen, Nichtmetallen oder Zusammensetzungen, nach Kontamination des Volumens der Stäbe bzw. Stabteile mit Metallen, Nichtmetallen oder Zusammensetzungen sowie nach Kontamination der Oberfläche der Stäbe bzw. Stabteile mit Staub (z.B. Silicium-Staub) oder nach Kombinationen der genannten Merkmale klassifiziert werden.

Weitere bevorzugte Klassifikationsmerkmale sind Lufttemperatur und Zusammensetzung (inkl. Verunreinigungen) beim Stabausbau und in der Zeit bis zum Klassifizieren, Zustand des Abscheidereaktors nach Abscheidung (Dichtigkeit, Beläge mit verschiedenen Stoffen), eventueller Kontakt der Stäbe bzw. Stabteile mit Fremdmaterialien.

Auch die Kristallstruktur der Stäbe bzw. Stabteile, die Kristallitgröße, -art, -form und Anordnung in Bereichen innerhalb oder auf der Oberfläche von Stäben bzw. Stabteilen, die Grenzfläche der Filamentstäbe zum abgeschiedenen Silicium (Farbe, Form, Dicke und Zusammensetzung einer evtl. existierenden Zwischenschicht, Stärke der Verbindung etc.) sowie das Vorhanden- oder Nichtvorhandensein von (z.B. gasgefüllten) Hohlräumen innerhalb der Stäbe bzw. Stabteile und Kombinationen der genannten Merkmale sind geeignete Klassifikationsmerkmale.

Schließlich kann auch nach dem Reaktionsverhalten der Stäbe bzw. Stabteile mit verschiedenen Chemikalien, dem Geruch der Stäbe bzw. Stabteile sowie der Teilchenemission der Stäbe bzw. Stabteile klassifiziert werden.

Die Erfindung sieht vorzugsweise auch vor, einen Teil eines Siliciumstabs zu separieren, um diesen Teil anhand eines Klassifikationsmerkmals zu klassifizieren, z.B. durch Entfernen der Oberfläche oder Zerbrechen des Stabes in grobe Stücke.

Besonders bevorzugt erfolgt zusätzlich nach der Zerkleinerung in Bruchstücke eine Klassifikation der Bruchstücke anhand wenigstens eines Klassifikationsmerkmals ausgewählt aus der Gruppe bestehend aus Porosität, Risse, Löcher, Flecken, Stabdurchmesser und -form.

Auch ist es bevorzugt vor und während der Abscheidung zu klassifizieren. Wie zuvor bereits erwähnt, ist es bevorzugt, mehrere Reaktoren zu betrachten und die polykristallinen Siliciumstäbe aus diesen Reaktoren zu klassifizieren.

Geeignete Klassifikationsmerkmale vor der Abscheidung sind Reaktionsgase (Verunreinigungen mit Metallen, Nichtmetallen und Fremdgasen) und die verwendeten Filamentstäbe (Dicke, Form, Länge, Verunreinigung auf der Oberfläche und im Volumen).

Während der Abscheidung kommt ein Klassifikationsmerkmal, ausgewählt aus der Gruppe bestehend aus gewähltem Reaktortyp, gewählter Ausstattung des Reaktors (Elektroden, Düsen, Dichtungen etc.), Abscheidetemperatur sowie deren Verlauf während der Abscheidung, Strömungsgeschwindigkeit der Reaktionsgase sowie deren Verlauf während der Abscheidung, Zusammensetzung und Konzentration der Reaktionsgase sowie deren Verlauf während der Abscheidung und Abscheidedauer in Betracht. Auch ist es bevorzugt, zwei oder mehrere Klassifikationsmerkmale aus der genannten Gruppe zu kombinieren.

In einer bevorzugten Ausführungsform erfolgt eine Klassifikation nach der Position im Stab.
Dies ist beispielsweise vorgesehen, wenn weitgehend kompaktes Material im Siemensreaktor abgeschieden wird, wie es für anspruchsvolle Kundenprozesse benötigt wird. Wie zuvor erwähnt fallen an bestimmten Stabpositionen auch poröse Anteile an. Insbesondere die Staboberteile sind oftmals stark porös. Es ist vorgesehen, die Stabpositionen nach kompakt und porös zu klassifizieren. Dadurch werden die Stabpositionen den zwei Qualitätsklassen kompakt und porös zugeordnet. Die porösen Stabteile werden abgetrennt, so dass Stabteile resultieren, die nur kompakt und Stabteile, die auch poröse Anteile beinhalten. Die Stabteile, die auch poröse Anteile beinhalten, werden durch Zerkleinern in Bruchstücke für die Solarindustrie weiterverarbeitet (Produktklasse Solar). Die kompakten Stabteile werden der Produktklasse Halbleiter (FZ, CZ) zugeordnet. Gegebenenfalls erfolgt eine Zerkleinerung der kompakten Stabteile in Bruchstücke.

Die Vorteile dieser Ausführungsform ergeben sich daraus, dass poröse Anteile bei der Abscheidung nun die Performance des Kristallisationsprozesses nicht mehr beeinflussen können, da sie zuvor separiert wurden. Im Gegenzug werden die porösen Stabteile nur der Produktklasse Solar zugeordnet und dort weiterverarbeitet. Dabei erfüllen die porösen Teile nicht nur die Anforderungen für Solarsilicium, sondern führen sogar zu einer Verbesserung der Performance. Dies ermöglicht es, bei der Produktion von kompaktem Material schneller und damit kostengünstiger abzuscheiden.

In einer weiteren bevorzugten Ausführungsform erfolgt eine Klassifikation nach Position im Reaktor.

Dem liegt die Überlegung zugrunde, dass Stäbe nach ihrer Position im Reaktor während der Abscheidung selektiert werden.

Die Anordnung der Stäbe im Reaktor hat Einfluss auf die Qualität der abgeschiedenen Stäbe. Moderne Reaktoren umfassen wenigstens 20 Filamentstäbe, die als Trägerkörper zur Abscheidung von polykristallinem Silicium dienen. Ein Reaktor sieht auch Gaseinlassöffnungen für Reaktionsgas in der Reaktorkammer vor, bei denen es sich um Düsen handelt, die bezüglich einer Bodenplatte der Reaktorkammer senkrecht nach oben ausgerichtet sind. Es kann auch eine Düse im Zentrum der Bodenplatte vorgesehen sein. Eine oder mehrere Abgasöffnungen werden bevorzugt in der Reaktormitte um die zentralen Düsen herum oder neben den zentralen Düsen platziert und/oder zwischen Reaktorwand und den äußeren Siliciumstäben platziert.

Vorzugsweise weist die Reaktorkammer einen runden oder einen an die Zahl der Filamentstäbe und eine optimale Raumnutzung angepassten, beispielsweise sechseckigen Querschnitt auf.

Dabei ist es vorteilhaft, wenn jeder Siliciumstab (davon ausgenommen Stäbe, die neben der Reaktorwand stehen) in einem Abstand von 150 bis 450 mm drei weitere Siliciumstäbe und eine bis drei Zugasdüsen besitzt. Jene drei weiteren Siliciumstäbe werden als benachbarte Stäbe oder Nachbarstäbe bezeichnet. Vorzugsweise liegt der Abstand zu Düsen und Nachbarstäben zwischen 200 und 350 mm. Die einzelnen Abstände zwischen den benachbarten Siliciumstäben bzw. Düsen können sich unterscheiden, liegen jedoch vorzugsweise zwischen 150 und 450 mm, besonders bevorzugt zwischen 200 und 350 mm. Vorzugsweise beträgt eine Differenz in den Entfernungen zu den einzelnen benachbarten Siliciumstäben und Düsen weniger als 50%, besonders bevorzugt weniger als 25% und ganz besonders bevorzugt weniger als 10%. Die Siliciumstäbe neben der Reaktorwand haben im gleichen Abstand nur 1 bis 3 drei weitere Siliciumstäbe und 1 bis 3 Gaseinlassöffnungen. Die Winkel zwischen den Richtungen von Siliciumstab zu den Nachbarstäben und vom Siliciumstab zu den Nachbardüsen liegen vorzugsweise zwischen 90 und 150°, besonders bevorzugt zwischen 105 und 135°, ganz besonders bevorzugt um 115-125°.

Werden polykristalline Siliciumstäbe in Reaktoren mit einer solchen Stabanordnung hergestellt, haben diese signifikant weniger Popcorn.

Bei gleichbleibender Stabqualität lassen sich (z.B. aufgrund höherer Temperatur der Siliciumstäbe) deutlich schnellere und dadurch wirtschaftlichere Abscheideprozesse fahren.

Grundsätzlich können Stäbe in der Mitte des Reaktors höhere Temperaturen erreichen und damit schneller und poröser wachsen als die außen, nahe der Reaktorwand gelegenen Stäbe.

Durch Selektion der Stäbe konnte innerhalb einer Reaktorfüllung Material für zwei unterschiedliche Qualitätsklassen abgeschieden werden, nämlich beinahe vollständig kompaktes Material, das nach Reinigung für Halbleiterprozesse tauglich ist sowie günstiges, poröses Silicium, wie es für Solarprozesse benutzt wird. Die Gesamtkosten lagen dabei niedriger als bei getrennter Herstellung der beiden Materialien.

In einer weiteren bevorzugten Ausführungsform erfolgt eine Klassifikation nach morphologischer Ausprägung.
In bestimmten Fällen ist es nicht möglich, aus der Position des Siliciums im Stab oder des Stabes im Reaktor die Morphologie und damit die Tauglichkeit des Materials für bestimmte Kundenprozesse vorherzusagen.

In diesen Fällen kann direkt nach dem Ausbau der Stäbe eine Klassifizierung anhand der Morphologie der Stäbe (Löcher, Risse etc.) getroffen werden: Dabei werden entweder ganze Stäbe oder auch Teile dieser Stäbe (z.B. auch abgeschälte Oberfläche) in getrennte Qualitätsklassen klassifiziert.

Dazu kommt beispielsweise ein Verfahren zur kontaminationsfreien und zerstörungsfreien Prüfung eines Polysiliciumformkörpers auf einen Materialfehler in Frage, bei dem der Polysiliciumformkörper mit Ultraschallwellen durchstrahlt wird, wobei die Ultraschallankopplung mittels blasenfreien vollentsalzten Wassers in Wasserstrahltechnik erfolgt, wobei die Ultraschallwellen nach Durchlaufen des Polysiliciumformkörpers von einem Ultraschallempfänger registriert werden und so Materialfehler im Polysilicium detektiert werden. Details zu diesem Verfahren sind US 20080053232 A1 zu entnehmen. Durch das Verfahren kann nach Defekten mit einer Projektionsfläche größer als 0,03 mm² sortiert werden. Ein mögliches Klassifikationsmerkmal stellt als das Vorhandensein bzw. Nichtvorhandensein von Defekten dieser Größe dar. Demzufolge wird in zwei Qualitätsklassen sortiert. Beim untersuchten Polysiliciumformkörper kann es sich um einen polykristallinen Siliciumstab oder um ein abgetrenntes Stabteil handeln.

Die Qualitätsklasse mit Defekten wird einer anderen Weiterverarbeitung und damit ggf. einer anderen Produktklasse zugeführt als die andere Qualitätsklasse.

Neben den genannten Klassifikationsmerkmalen kann auch nach weiteren Auffälligkeiten klassifiziert werden.

Bei weiteren Auffälligkeiten kann es sich beispielsweise um Beläge oder Flecken handeln, die auch nur auf einem einzelnen Stab einer Charge auftreten können.

Falls die Auffälligkeit nur an einem Stab auftritt, wird nur dieser gegebenenfalls aussortiert. Der Rest der Charge wird der geplanten Verwendung zugeführt. Der aussortierte Stab wird einer anderen, darunterliegenden Qualitätsklasse zugeordnet.

Es ist auch bevorzugt, solche Klassifikationen nach morpholgischen Ausprägungen sowie nach sonstigen Auffälligkeiten nach dem Zerkleinern von Siliciumstäben, also an den Bruchstücken vorzunehmen.

In diesem Fall werden die Bruchstücke anhand wenigstens eines Merkmals in wenigstens zwei Qualitätsklassen klassifiziert, wobei jene wenigstens zwei Qualitätsklassen wenigstens zwei unterschiedlichen Weiterverarbeitungsschritten zugeführt werden, wobei jene wenigstens zwei unterschiedlichen Weiterverarbeitungsschritte zu wenigstens zwei Produktklassen führen.

Diese Klassifikation von Bruchstücken kann auch nach einer nasschemischen Behandlung erfolgen. Gerade nach einer nasschemischen Behandlung treten oftmals Flecken an einzelnen Bruchstücken auf. Eine geeignete nasschemische Behandlung ist beschrieben in EP 0 905 796 B1.

Besonders bevorzugt ist es, dem Mitarbeiter der Reinigungslinie einen Fleckenkatalog an die Hand zu geben, in dem typischerweise auftretende Flecken an Bruchstücken dargestellt sind. Danach kann der Mitarbeiter eine Klassifizierung der Bruchstücke vornehmen.

Ebenso ist es von Vorteil, wenn dem Mitarbeiter auch eine Verwendungsmatrix zur Verfügung gestellt wird, die ihm aufgrund der Klassifikation nach Fleckenkatalog Auskunft, welcher Verwendung das auffällige Bruchstück zugeführt werden soll.

Diese Maßnahmen wie Bereitstellen eines Flecken- oder allgemein Merkmalskatalogs und einer Verwendungsmatrix sind bei allen Klassifizierungen, die auf optischer Beurteilung durch eine Person beruhen, vorteilhaft.

Die Klassifikation der polykristallinen Siliciumstäbe kann bei allen Ausführungsformen vor oder nach Entfernen der Kohlelektrode erfolgen. Das Entfernen der Kohleelektrode, sowie kohlebehafteter Si-Bruchstücke wird nicht als Klassifizierungsschritt im Sinne dieser Erfindung betrachtet.

Ein weiteres Klassifikationsmerkmal stellt der Dotierstoffgehalt dar. Dabei kann die Messung an verschiedenen Stabstellen erfolgen, indem eine Probe entnommen wird.

Dazu werden kleine Proben, die aus einem polykristallinen Siliciumstab erzeugt wurden (z.B. durch Ausbohren), in ein Siliciumgefäß eingebracht und mit dem Siliciumgefäß zu einem Einkristall verarbeitet. Hier müssen allerdings von den ermittelten Gesamtverunreinigungen die Konzentrationen im Bulk und die Kontamination des Siliciumgefäßes abgezogen werden.

Dotierstoffe (B, P, As, Al) werden dann nach SEMI MF 1398 an einem aus dem polykristallinen Material erzeugten FZ-Einkristall (SEMI MF 1723) mittels Photolumineszenz analysiert.

Von dem aus einem polykristallinen Siliciumstab oder aus polykristallinen Siliciumbruchstücken mittels FZ erzeugten einkristallinen Stab wird eine Scheibe (Wafer) abgetrennt, mit HF/HNO₃ geätzt, mit 18 MOHm Wasser gespült und getrocknet. An dieser Scheibe werden die Photolumineszenzmessungen durchgeführt.

Die wenigstens zwei unterschiedlichen Weiterverarbeitungsschritte können beispielsweise darin bestehen, dass eine Qualitätsklasse mit einem zu hohen Dotierstoffgehalt an der Oberfläche einer nasschemischen Behandlung zugeführt wird, während die andere Qualitätsklasse ohne einen solchen Reinigungsschritt weiterverarbeitet wird.

Bezüglich der wenigstens zwei Produktklasse ist zunächst zu unterscheiden zwischen Halbleiter und Solar.

Bei Halbleiter wird weiter differenziert nach FZ (Produkt: Stab) oder CZ-Bruch, der gereinigt oder ungereinigt sein kann.

Bei Solar wird differenziert nach Art des Abscheidungsprozesses.

Eine Produktklasse sieht vor einen polykristallinen Siliciumstab mit einem Durchmesser von wenigstens 150 mm, beinhaltend einen Kern (A) mit einer Porosität von 0 bis weniger als 0,01 und einen Dünnstab (Trägerkörper, Filament) und mindestens zwei nachfolgende Bereiche B und C, die sich in ihrer Porosität um einen Faktor von 1,7 bis 23 unterscheiden, wobei der äußere Bereich C weniger porös ist als der Bereich B. Ein Bereich des Siliciumstabs mit einer Porosität von kleiner als 0,01 wird im Rahmen der Erfindung als kompakt angesehen. Der Kern des Siliciumstabs ist also bei dieser Produktklasse kompakt. Ein Bereich mit einer Porosität von 0,01 bis 0,1 wird als "dichtes Material" oder "dichte Schicht" bezeichnet. Bei Bereich C handelt es sich um dichtes Material.

Vorzugsweise erstreckt sich Kern A über einen Durchmesserbereich von bis zu 60 mm. Der Dünnstab, auf dem Kern A abgeschieden ist, hat typischerweise eine Ausdehnung von wenigen mm bis zu 12 mm. Somit startet Kern A typischerweise z.B. bei einem Durchmesser von 9 mm und erstreckt sich bis zu einem Durchmesser von maximal 60 mm. Vorzugsweise erstreckt sich Kern A bis zu einem Durchmesser von maximal 50 mm, besonders bevorzugt maximal 40 mm.

Vorzugsweise weist der auf den Kern A folgende Bereich B die größte Porosität von 0,06 bis 0,23 auf und erstreckt sich über einen Durchmesserbereich von 15 % bis 90 % des Durchmessers des Siliciumstabs. Vorzugsweise erstreckt sich Bereich B über einen Durchmesserbereich von 20-80%.

Vorzugsweise weist der nachfolgende Bereich C eine geringere Porosität von 0,01 bis 0,1 auf und erstreckt sich über einen Durchmesserbereich von 50 % bis 100 % des Gesamtdurchmessers des Siliciumstabs. Vorzugsweise erstreckt sich Bereich C über einen Durchmesserbereich von 60-100%, besonders bevorzugt über einen Bereich von 70-100%.

Vorzugsweise ist die Porosität im Bereich C konstant. Besonders bevorzugt ist es, wenn die Porosität im Bereich C mit zunehmendem Durchmesser abnimmt.

Weiterhin ist es bevorzugt, wenn auf die porösen Bereiche B und C eine abschließende Schicht Z aufgebracht ist, mit einer Porosität von 0 bis weniger als 0,01 (kompakt) in einem Durchmesserbereich von 90 % bis 100 % des Gesamtdurchmessers. Ein besonders bevorzugter Durchmesserbereich beträgt 95-100%. Vorzugsweise hat die Z-Schicht eine Dicke von wenigstens 7,5 mm.

Durch Zerkleinerung eines solchen polykristallinen Siliciumstabs lassen sich polykristalline Siliciumbruchstücke herstellen.

Die Zerkleinerung der Stäbe erfolgt vorzugsweise analog EP 2 423 163 A1 mit anschließendem Entstauben der Bruchstücke mittels Druckluft oder Trockeneis. Ebenso ist es bevorzugt, die Stäbe analog US 8074905 in Bruchstücke zu brechen, in Bruchstücke von Größenklassen von etwa 0,5 mm bis 200 mm zu klassieren bzw. zu sortieren und anschließend einer nasschemischen Reinigung - wie in EP 0 905 796 B1 beschrieben - zu unterziehen.

Die dabei erhaltene Menge an polykristallinen Siliciumbruchstücken zeichnet sich dadurch aus, dass sie Bruchstücke mit unterschiedlichen Porositäten bzw. Bruchstücke, die Bereiche mit unterschiedlichen Porositäten umfassen, beinhaltet.

Somit kann auch eine Klassifikation der Bruchstücke nach Porosität erfolgen.

Die Porositäten einzelner Bruchstücke variieren von 0 bis 0,25.

Es ergeben sich zwei Qualitätsklassen:
Einzelne Bruchstücke weisen eine Porosität von 0 bis weniger als 0,01 auf und stammen vom kompakten Kern des Siliciumstabs oder von der optional vorhandenen Z-Schicht.

Andere Bruchstücke sind mehr oder weniger porös und weisen Porositäten von 0,01 bis 0,25 auf.

Die Gesamtporosität einer Probe setzt sich zusammen aus der Summe der Hohlräume, die untereinander und mit der Umgebung in Verbindung stehen und den nicht miteinander verbundenen Hohlräumen. Die Gesamtporosität, d.h. der Anteil des Gesamtporenvolumens (offene und geschlossene Poren) am Gesamtvolumen des Polysiliciums wird ermittelt nach DIN-EN 1936 aus der Berechnung aus Roh- und Reindichte, d.h. Gesamtporosität = 1 - (Rohdichte/2,329[g/cm³]).

Die Rohdichte ist definiert als die Dichte des Polysiliciums einschließlich des Porenraums im trockenen Zustand nach DIN-EN 1936 (Wägung volumenmäßig definierter Prüfkörper oder Messung des Auftriebs der gesättigten Probe in Quecksilber mit einer hydrostatischen Waage).

Der kompakte Kern A des polykristallinen Siliciumstabs weist vorzugsweise eine Rohdichte von 2,329 auf (Porosität 0). Bereich B weist vorzugsweise eine Rohdichte von 1,8 bis 2,2 auf. Bereich C weist vorzugsweise eine Rohdichte von 2,1 bis 2,3 auf. Schicht Z weist vorzugsweise eine Rohdichte von 2,25 bis 2,329 auf.

Eine weitere Produktklasse sieht einen polykristallinen Siliciumstab, umfassend eine äußere Schicht aus polykristallinem Silicium mit einer Dicke von 0,01 bis 20 mm, wobei diese äußere Schicht Kristallite mit einer mittleren Größe von mehr als 20 µm beinhaltet, vor.

Vorzugsweise beträgt die mittlere Größe der Kristallite der äußeren Schicht maximal 80 µm. Vorzugsweise beträgt die mittlere Größe der Kristallite der äußeren Schicht 25-60 µm, besonders bevorzugt 30-60 µm, ganz besonders bevorzugt 35-55 µm.

Vorzugsweise weist der polykristalline Siliciumstab unterhalb der äußeren Schicht eine poröse oder zerklüftete Struktur auf.

Vorzugsweise ist die Struktur im Innern des polykristallinen Siliciumstabs gleichartig (weist also im Innern die gleiche Kristallstruktur, Kristallitgröße usw. auf), wobei sie Poren, Fugen, Spalten, Risse und Klüfte umfasst.

Vorzugsweise besteht die äußere Schicht aus Kristalliten mit einer mittleren Größe, die größer ist als die mittlere Größe der Kristallite unterhalb der äußeren Schicht.

Die Erfindung ermöglicht es also, nach kompakten und porösen Anteilen des polykristallinen Siliciums zu klassifizieren. Die Abscheideprozesse, die eine großen Kostenblock bei der Polysiliciumherstellung bedeuten, können deutlich flexibler gefahren werden. Hochwertiges Material wird auch einer hochwertigen Verwendung zugeführt. Kompaktes Material, das bei der Herstellung von Solarprodukten entsteht, kann auch für hochwertigere Produkte (CZ) verwendet werden.

## Patentansprüche

1. Verfahren zur Herstellung von polykristallinem Silicium, umfassend Abscheiden von polykristallinem Silicium auf in wenigstens einem Reaktor befindlichen Trägerkörpern, wodurch polykristalline Siliciumstäbe erhalten werden, Ausbau der polykristallinen Siliciumstäbe aus dem wenigstens einen Reaktor, Zerkleinern der ausgebauten polykristallinen Siliciumstäbe in Bruchstücke, **dadurch gekennzeichnet, dass** nach dem Ausbau der polykristallinen Siliciumstäbe aus dem wenigstens einen Reaktor und vor dem Zerkleinern der ausgebauten polykristallinen Siliciumstäbe in Bruchstücke das in Stabform vorliegende polykristalline Silicium anhand wenigstens eines Merkmals in wenigstens zwei Qualitätsklassen klassifiziert wird, wobei jene wenigstens zwei Qualitätsklassen separaten Zerkleinerungsschritten zugeführt werden.

2. Verfahren nach Anspruch 1, wonach es sich beim wenigstens einen Klassifikationsmerkmal um das Merkmal "Position des Siliciums im Stab" handelt.

3. Verfahren nach Anspruch 1 oder nach Anspruch 2, wobei es sich beim wenigstens einen Klassifikationsmerkmal um das Merkmal "Position des Stabes im Reaktor" handelt.

4. Verfahren nach einem der Ansprüche 1 bis 3, wobei es sich beim wenigstens einen Klassifikationsmerkmal um ein optisch erkennbares Merkmal handelt.

5. Verfahren nach einem der Ansprüche 1 bis 4, wobei es sich beim wenigstens einen Klassifikationsmerkmal um ein messbares Merkmal handelt.

6. Verfahren nach Anspruch 5, wobei es sich beim wenigstens einen Klassifikationsmerkmal um den Stabdurchmesser handelt.

7. Verfahren nach einem der Ansprüche 1 bis 6, wobei es sich beim wenigstens einen Klassifikationsmerkmal um das Merkmal "Kontamination der Oberfläche oder des Volumens" handeln.

8. Verfahren nach einem der Ansprüche 1 bis 7, wobei ganze polykristalline Siliciumstäbe wenigstens zwei Qualitätsklassen zugeordnet werden.

9. Verfahren nach einem der Ansprüche 1 bis 6, wobei von einem polykristallinen Siliciumstab abgetrennte Teile wenigstens zwei Qualitätsklassen zugeordnet werden.

10. Verfahren nach einem der Ansprüche 1 bis 7, wobei nach dem Zerkleinern der polykristallinen Siliciumstäbe in Bruchstücke eine Klassifikation der Bruchstücke anhand wenigstens eines Merkmals ausgewählt aus der Gruppe bestehend aus Porosität, Risse, Löcher, Flecken, Stabdurchmesser und Stabform erfolgt, wobei eine Klassifikation in wenigstens zwei Qualitätsklassen erfolgt.

## Claims

1. Process for producing polycrystalline silicon, comprising depositing polycrystalline silicon on support bodies present in at least one reactor to obtain polycrystalline silicon rods, deinstalling the polycrystalline silicon rods from the at least one reactor, comminuting the deinstalled polycrystalline silicon rods into chunks, wherein the deinstallation of the polycrystalline silicon rods from the at least one reactor is followed by, and the comminution of the deinstalled polycrystalline silicon rods into chunks is preceded by, classification of the polycrystalline silicon in rod form into at least two quality classes on the basis of at least one feature, said at least two quality classes being sent to separate comminuting steps.

2. Process according to Claim 1, wherein the at least one classification feature is the feature "position of the silicon in the rod".

3. Process according to Claim 1 or according to Claim 2, wherein the at least one classification feature is the feature "position of the rod in the reactor".

4. Process according to any of Claims 1 to 3, wherein the at least one classification feature is a visually discernible feature.

5. Process according to any of Claims 1 to 4, wherein the at least one classification feature is a measurable feature.

6. Process according to Claim 5, wherein the at least one classification feature is the rod diameter.

7. Process according to any of Claims 1 to 6, wherein the at least one classification feature is the feature "contamination of the surface or of the volume".

8. Process according to any of Claims 1 to 7, wherein whole polycrystalline silicon rods are assigned to at least two quality classes.

9. Process according to any of Claims 1 to 6, wherein parts separated from one polycrystalline silicon rod are assigned to at least two quality classes.

10. Process according to any of Claims 1 to 7, wherein the comminution of the polycrystalline silicon rods into chunks is followed by a classification of the chunks on the basis of at least one feature selected from the group consisting of porosity, cracks, holes, stains, rod diameter and rod shape, classification being effected into at least two quality classes.

## Revendications

1. Procédé pour la production de silicium polycristallin, comprenant le dépôt de silicium polycristallin sur des corps porteurs se trouvant dans au moins un réacteur, de sorte qu'on obtient des barres de silicium polycristallin, le retrait des barres de silicium polycristallin dudit au moins un réacteur, la fragmentation en éclats des barres de silicium polycristallin retirées, **caractérisé en ce qu'**après le retrait des barres de silicium polycristallin dudit au moins un réacteur et avant la fragmentation en éclats des barres de silicium polycristallin retirées, on classe en au moins deux classes de qualité, à l'aide d'au moins une caractéristique, le silicium polycristallin se trouvant sous forme de barres, ces au moins deux classes de qualité étant envoyées à des étapes de fragmentation distinctes.

2. Procédé selon la revendication 1, selon lequel pour ce qui est de ladite au moins une caractéristique de classification il s'agit de la caractéristique « position du silicium dans la barre ».

3. Procédé selon la revendication 1 ou selon la revendication 2, dans lequel pour ce qui de ladite au moins une caractéristique de classification il s'agit de la caractéristique « position de la barre dans le réacteur ».

4. Procédé selon l'une quelconque des revendication 1 à 3, dans lequel pour ce qui de ladite au moins une caractéristique de classification il s'agit d'une caractéristique discernable optiquement.

5. Procédé selon l'une quelconque des revendication 1 à 4, dans lequel pour ce qui de ladite au moins une caractéristique de classification il s'agit d'une caractéristique mesurable.

6. Procédé selon la revendication 5, dans lequel pour ce qui de ladite au moins une caractéristique de classification il s'agit du diamètre de la barre.

7. Procédé selon l'une quelconque des revendications 1 à 6, selon lequel pour ce qui de ladite au moins une caractéristique de classification il s'agit de la caractéristique « contamination de la surface ou du volume ».

8. Procédé selon l'une quelconque des revendication 1 à 7, dans lequel toutes les barres de silicium polycristallin sont affectées à au moins deux classes de qualité.

9. Procédé selon l'une quelconque des revendication 1 à 6, dans lequel des parties distinctes d'une barre de silicium polycristallin sont affectées à au moins deux classes de qualité.

10. Procédé selon l'une quelconque des revendication 1 à 7, dans lequel après la fragmentation en éclats des barres de silicium polycristallin on effectue une classification des éclats à l'aide d'au moins une caractéristique choisie dans le groupe constitué par la porosité, les fissures, les trous, les taches, le diamètre de la barre et la forme de la barre, une classification s'effectuant en au moins deux classes de qualité.
